# EUROPEAN PATENT APPLICATION

(11) **EP 2 542 031 A1**
(43) Date of publication of application: **02.01.2013**
(21) Application number: 11747290.2
(22) Date of filing: 21.02.2011
(51) Int. Cl.: H05B 33/10, H01L 51/50, H05B 33/12, H05B 33/22

(54) **MANUFACTURING METHOD FOR LIGHT-EMITTING DEVICES**

(30) Priority: 25.02.2010 JP 2010039996
(71) Applicant: Sumitomo Chemical Company, Limited, Tokyo 104-8260 (JP)
(72) Inventor: GODA, Tadashi, Tsukuba-shi Ibaraki 305-0821 (JP)
(74) Representative: Jackson, Martin Peter
(86) International application number: PCT/JP2011/053692
(87) International publication number: WO 2011/105329

(57) **Abstract**

Provided is a method for manufacturing a light-emitting device (21) in which formation of an undesired hole in an organic EL layer is suppressed. The method is a method for manufacturing a light-emitting device including a supporting substrate (11), a plurality of partitions (17) extending in a prescribed line direction on the supporting substrate and provided at a prescribed interval in a column direction that is a different direction from the line direction, a first electrode (12), a second electrode (16), an organic electroluminescent (EL) layer, and a plurality of organic EL elements (22) provided in a concave portion (18) that is between the partitions. The method includes a step of supplying an ink including a material to be the organic EL layer to one concave portion a plurality of times by shifting the ink supply position in the column direction to supply the ink to each concave portion along the line direction and solidifying the ink to form the organic EL layer.

## Description

### TECHNICAL FIELD

The present invention relates to a method for manufacturing a light-emitting device.

### BACKGROUND ART

Display devices have various types such as liquid crystal display devices and plasma display devices. As one type of these display devices, a display device using, as the light source of pixels, organic electroluminescent elements (organic EL elements) has come to be put into practical use. This type of display device comprises a plurality of organic EL elements arrayed on a substrate. On the substrate, a partition for dividing the organic EL element is placed in a stripe pattern. Each organic EL element is provided in a region divided by the substrate and the partition in a stripe pattern.
Each of the organic EL elements is arrayed between the partitions (also called a "concave portion") and each of the organic EL elements is arrayed between the partitions at a prescribed interval along an extending direction of the partition. In other words, the organic EL elements are arrayed in a matrix pattern.

The organic EL element is constituted by layering a first electrode, one or more organic EL layers, and a second electrode in this order such that the first electrode becomes nearer to the supporting substrate than the second electrode. The organic EL layer provided between the first electrode and the second electrode can be formed by a coating method. For example, the organic EL layer can be formed by supplying an ink comprising a material to be the organic EL layer to a region (concave portion) divided by the partition and by solidifying the ink.
The supply of the ink can be performed, for example, by a nozzle printing method. Thus, by forming the organic EL layer on the first electrode and by forming the second electrode by a prescribed method, a plurality of organic EL elements can be formed on the supporting substrate (for example, see Patent Document 1).

### RELATED ART DOCUMENTS

### Patent Document

Patent Document 1: JP 2008-218250 A

### DISCLOSURE OF INVENTION

### PROBLEM TO BE SOLVED BY THE INVENTION

For example, when a display device is increased in size, the size of each pixel is more enlarged and the width of the concave portion that is a space between the partitions and that defines the width of the pixel becomes correspondingly larger. When the ink is supplied to such a wide concave portion by the nozzle printing method, the ink may not wet-spread over the space between the partitions, that is, the concave portions, so that an uncoated portion may occur in a part of the concave portion. When the ink is solidified in a state in which an uncoated portion occurs, a hole is formed in the organic EL layer, so that there is the problem in that an element failure occurs.
Accordingly, it is an object of the present invention to provide a production method of a light-emitting device capable of suppressing the formation of an undesired hole in the organic EL layer.

### MEANS FOR SOLVING PROBLEM

The present invention provides [1] to [5] below.
[1] A method for manufacturing a light-emitting device that comprises a supporting substrate, a plurality of partitions extending in a prescribed line direction on the supporting substrate and provided at a prescribed interval in a column direction that is a different direction from the line direction, and a plurality of organic electroluminescent elements provided in a concave portion that is between the partitions, each element comprising a first electrode, a second electrode, an organic electroluminescent layer sandwiched between the first electrode and the second electrode, the method comprising the steps of:
   preparing the supporting substrate provided with the first electrode of each organic electroluminescent element and the partitions;
   supplying an ink comprising a material to be the organic electroluminescent layer to one concave portion a plurality of times by shifting an ink supply position in the column direction to supply the ink to each concave portion along the line direction and solidifying the ink, thereby forming the organic electroluminescent layer; and
   forming the second electrode.
[2] The method for manufacturing the light-emitting device according to above [1], wherein the step of forming the organic electroluminescent layer comprises: supplying the ink comprising a material to be the organic electroluminescent layer to the each concave portion by reciprocating the supply position of the ink from one end to the other end of the line direction and from the other end to the one end of the line direction, in one or two or more times, with shifting the ink supply position when supplying the ink from the one end to the other end and the ink supply position when supplying the ink from the other end to the one end, in the column direction; and solidifying the ink, thereby forming the organic electroluminescent layer.
[3] The method for manufacturing the light-emitting device according to above [1] or [2], wherein at the step of forming the organic electroluminescent layer, an interval between the supply positions in the each concave portion that are different from each other in the column direction is made equal, and
   the partitions are provided such that the interval between centers of the partitions in the column direction becomes an integral multiple of two or more times the interval between the supply positions.
[4] The method for manufacturing the light-emitting device according to any one of above [1] to [3], wherein at the step of forming the organic electroluminescent layer, the ink is supplied such that each amount of the ink supplied to one concave portion a plurality of times is less than an amount of the ink required for supplying the ink to all the regions of the concave portion and the ink supplied a plurality of times to the concave portion is joined to each other and spread to all the regions of the concave portion.
[5] The method for manufacturing the light-emitting device according to any one of above [1] to [4], wherein at the step of forming the organic electroluminescent layer, the ink is discharged simultaneously through a plurality of nozzles using a plurality of nozzles discharging the ink.

### EFFECT OF THE INVENTION

According to the present invention, when a light-emitting device is manufactured, the formation of an undesired hole in the organic EL layer can be suppressed and consequently, the occurrence of the element failure can be suppressed.

### BRIEF DESCRIPTION OF DRAWINGS

FIG. 1 is a plan view schematically illustrating a light-emitting device.
FIG. 2 is a cross-sectional view schematically illustrating the light-emitting device.
FIG. 3 is a drawing (1) schematically illustrating an ink supplying step.
FIG. 4 is a drawing (2) schematically illustrating an ink supplying step.
FIG. 5 is a drawing (3) schematically illustrating an ink supplying step.

### DESCRIPTION OF EMBODIMENTS

A method for manufacturing a light-emitting device of the present invention is a method for manufacturing a light-emitting device comprising a supporting substrate, a plurality of partitions extending in a prescribed line direction on the supporting substrate and provided at a prescribed interval in a column direction that is a different direction from the line direction, and a plurality of organic electroluminescent elements provided in a concave portion that is between the partitions, each element comprising a first electrode, a second electrode, an organic electroluminescent layer sandwiched between the first electrode and the second electrode, and a plurality of organic electroluminescent elements provided in a concave portion that is between the partitions. The method comprises the steps of preparing the supporting substrate provided with the first electrode of each organic electroluminescent element and the partitions, supplying an ink comprising a material to be the organic electroluminescent layer to one concave portion a plurality of times by shifting an ink supply position in the column direction to supply the ink to each concave portion along the line direction, and solidifying the ink, thereby forming the organic electroluminescent layer, and forming the second electrode.

The light-emitting device is utilized, for example, as a display device. The display device comprises mainly an active matrix driving-type device and a passive matrix driving-type device. Although the present invention can be applied to both driving-types devices, in the present embodiment, as one example, a light-emitting device applied to an active matrix driving-type display device is described.

### <Composition of light-emitting device>

First, referring to drawings, the composition of the light-emitting device is described. In the descriptions below, the drawings are only schematically illustrated, the shape, the size, and the position of each component are schematically illustrated to such a degree as capable of comprehending the present invention, and each drawing should not be construed as limiting the scope of the present invention. In the drawings, the same components are indicated by attaching the same symbol and duplicate explanation may be omitted.

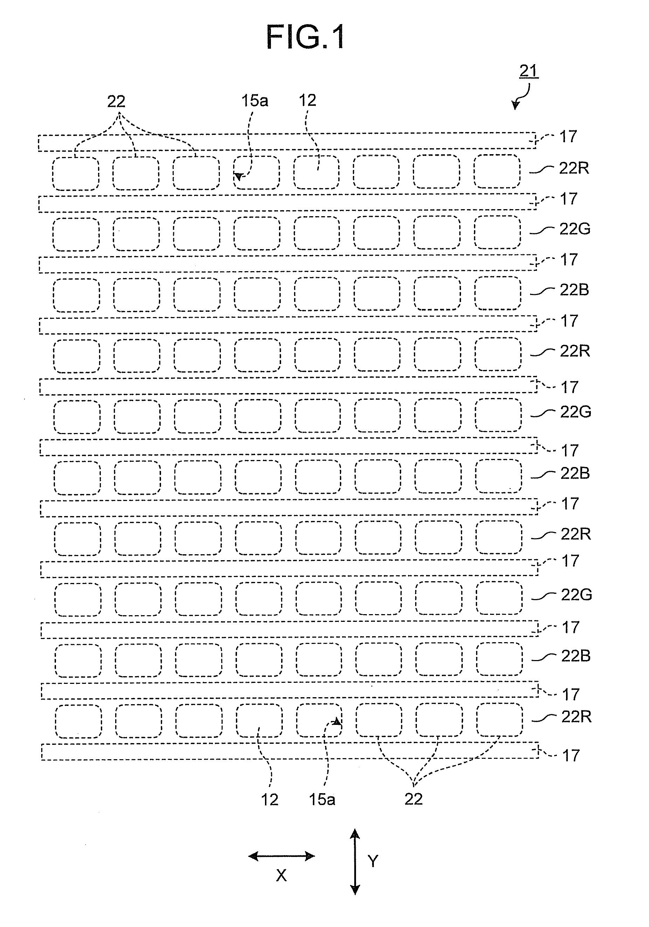

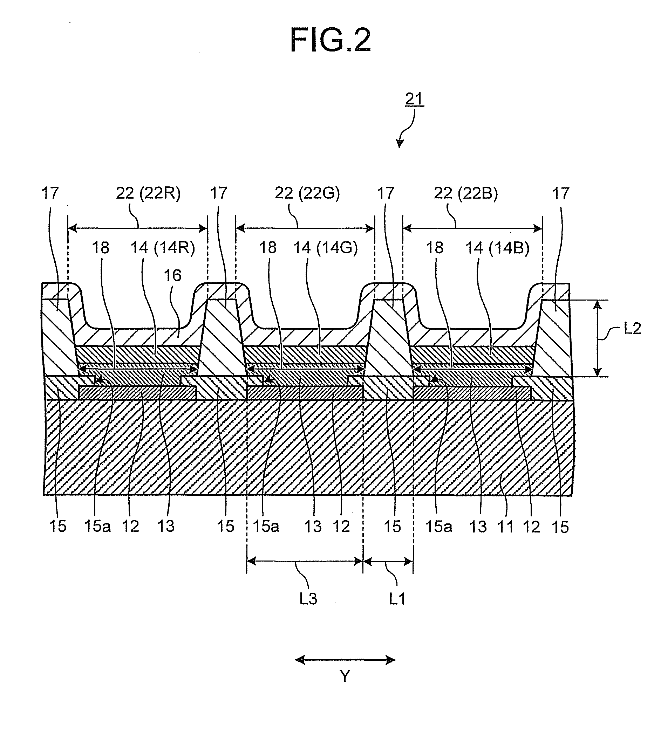

FIG. 1 is a plan view schematically illustrating a light-emitting device. FIG. 2 is a cross-sectional view schematically illustrating the light-emitting device. A light-emitting device 21 of the present embodiment comprises mainly a supporting substrate 11, a plurality of organic EL elements 22 formed on the supporting substrate 11, and a plurality of partitions 17 for dividing the organic EL elements on the supporting substrate 11.

As illustrated in FIG. 1 and FIG. 2, the partitions 17 extend substantially parallel to each other and in a linear manner in a prescribed line direction X on the supporting substrate 11. The partitions 17 are provided at a prescribed interval in a column direction Y that is a different direction from the line direction X. That is, the partitions 17 are provided in a stripe pattern. In the present embodiment, the line direction X and the column direction Y cross each other at right angle and both the line direction X and the column direction Y cross the thickness direction Z of the supporting substrate 11 at right angle. Hereinafter, a depression defined by a pair of partitions 17 adjacent to each other in the column direction Y and the supporting substrate 11 and extending in the line direction is a concave portion 18. On the supporting substrate 11, a plurality of concave portions 18 defined by the partitions 17 are defined. Each concave portion 18 corresponds to each prescribed line.

In the present embodiment, between the supporting substrate 11 and the partition 17, an insulation film 15 is provided. The insulation film 15 is provided, for example, for securing electric insulation between the organic EL elements 22 adjacent to each other in the line direction X or in the column direction Y. The insulation film 15 is formed in a lattice pattern and is constituted by integrally forming a plurality of belt-shaped portions extending in the line direction X and a plurality of belts extending in the column direction Y. An opening 15a of the insulation film 15 is formed at a position at which the insulation film 15 is overlapped with the organic EL element as viewed from a thickness direction of the supporting substrate 11 (hereinafter, also called "in a plan view").
The opening 15a of the insulation film 15 is formed, for example, in a substantially rectangular shape, an oval shape, a substantially circular shape, a substantially elliptical shape, or the like in a plan view. The lattice-patterned insulation film 15 is formed mainly in a region covering the periphery of a first electrode 12 described below so as to expose a part of the first electrode 12 and in a region excluding the first electrode 12 in a plan view. The above-described partitions 17 are provided on a plurality of belts comprised in a part of the insulation film and extending in the line direction X.

In the present embodiment, the organic EL elements 22 are provided between the partitions 17 (that is, the concave portion 18) adjacent to each other in the column direction Y and are arrayed at a prescribed interval in the line direction X in each space between the partitions 17. That is, in the present embodiment, the organic EL elements 22 are arrayed in a matrix pattern on the supporting substrate 11 and are provided at a prescribed interval in the line direction X and at a prescribed interval in the column direction Y. The organic EL elements 22 are not necessary to be physically separated from each other and may be electrically insulated with each other such that the organic EL elements 22 can be individually driven. Therefore, some layers (such as an electrode and an organic EL layer) comprised in one organic EL element 22 may be physically connected with another organic EL element 22.

The organic EL element 22 is constituted by providing the first electrode 12, the organic EL layer (light-emitting layer 14), and the second electrode 16 in this order such that the first electrode 12 becomes nearer to the supporting substrate 11.

The pair of electrodes comprising the first electrode 12 and the second electrode 16 are constituted by an anode and a cathode. That is, one of the first electrode 12 and the second electrode 16 is provided as the anode and the other is provided as the cathode. The first electrode 12 among the first electrode 12 and the second electrode 16 is provided nearer to the supporting substrate 11. The second electrode 16 is provided separated from the supporting substrate 11 more than the first electrode 12.

The organic EL element 22 comprises one or more organic EL layers. The organic EL layer means one or more layers sandwiched between the first electrode 12 and the second electrode 16. The organic EL element 22 comprises at least one light-emitting layer 14 as one or more organic EL layers. Between the pair of electrodes, not only the light-emitting layer 14, but also, if necessary, a prescribed layer is provided. For example, between the anode and the light-emitting layer 14, there are provided the hole injection layer, the hole transport layer, the electron block layer, and the like as the organic EL layer and between the light-emitting layer 14 and the cathode, there are provided the hole block layer, the electron transport layer, the electron injection layer, and the like as the organic EL layer.

The organic EL element 22 of the present embodiment comprises a hole injection layer 13 between the first electrode 12 and the light-emitting layer 14 as the organic EL layer.

Hereinafter, as one embodiment, there is described an organic EL element 22 constituted by layering the first electrode 12 functioning as the anode, the hole injection layer 13, the light-emitting layer 14, the second electrode 16 functioning as the cathode in this order such that the first electrode 12 becomes nearer to the supporting substrate 11.

The light-emitting device 21 of the present embodiment is an active matrix driving-type device. Therefore, the first electrode 12 is individually provided for each organic EL element 22. That is, organic EL elements 22 as many as first electrodes 12 are provided on the supporting substrate 11. For example, the first electrode 12 is formed in a plate shape and in a substantially rectangular shape in a plan view. The first electrode 12 is provided in a matrix pattern corresponding to a position at which each organic EL element 22 is provided on the supporting substrate 11. The first electrodes 12 are provided at a prescribed interval in the line direction X and at a prescribed interval in the column direction Y. That is, the first electrode 12 is provided between the partitions 17 adjacent to each other in the column direction Y in a plan view and in each space between the partitions 17, the first electrodes 12 are provided at a prescribed interval in the line direction X.

As described above, the lattice-patterned insulation film 15 is formed mainly in a region excluding the first electrode 12 in a plan view and a part thereof is formed by covering the periphery of the first electrode 12. That is, in the insulation film 15, the opening 15a for exposing a part of the first electrode 12 is formed. Through this opening 15a, a part of the surface of the first electrode 12 is exposed from the insulation film 15.

The hole injection layer 13 are provided while extending in the line direction X in a region sandwiched between the partitions 17 adjacent to each other. That is, the hole injection layer 13 is formed in a belt-shape in the concave portion 18 defined by the partitions 17 adjacent to each other in the column direction Y and is formed continuously ranging over the organic EL elements 22 adjacent to each other in the line direction X.

The light-emitting layer 14 is provided while extending in the line direction X in a region sandwiched between the partitions 17 adjacent to each other. That is, the light-emitting layer 14 is formed in a belt-shape in the concave portion 18 defined by the partitions 17 adjacent to each other in the column direction Y and is formed continuously ranging over the organic EL elements 22 adjacent to each other in the line direction X. The belt-shape light-emitting layer 14 is layered on the belt-shape hole injection layer 13.

In the case of a color display device, three types of organic EL elements 22 emitting any one type of light among red light, green light, and blue light are provided on the supporting substrate 11. A color display device can be achieved, for example, by repeatedly arraying the lines (I), (II), and (III) below in this order in the column direction Y:
(I) a line in which a plurality of organic EL elements 22R emitting red light are arrayed at a prescribed interval;
(II) a line in which a plurality of organic EL elements 22G emitting green light are arrayed at a prescribed interval; and
(III) a line in which a plurality of organic EL elements 22B emitting blue light are arrayed at a prescribed interval.

Thus, when the types of organic EL elements emitting different color light components are formed, the light-emitting layers emitting different color light components are provided for each type of the organic EL element emitting different color light components. In the present embodiment, the lines (i), (ii), and (iii) below in which three types of light-emitting layers 14R, 14G, and 14B respectively are provided are repeatedly arrayed in this order in the column direction Y:
(i) a line in which a light-emitting layer 14R emitting red light is provided;
(ii) a line in which a light-emitting layer 14G emitting green light is provided; and
(iii) a line in which a light-emitting layer 14B emitting blue light is provided.
   That is, the belt-shape light-emitting layers 14R, 14G, and 14B extending in the line direction X are sequentially layered on the hole injection layer 13 individually with an interval of two lines in the column direction Y.

The second electrode 16 is provided on the light-emitting layer 14. In the present embodiment, the second electrode 16 is formed integrally over the organic EL elements 22 and is provided as an electrode common to these organic EL elements 22. That is, the second electrode 16 is formed not only on the light-emitting layer 14, but also on the partitions 17 and is formed all over so that an electrode on the light-emitting layer 14 and an electrode on the partitions 17 line up.

### <Method for manufacturing a light-emitting device>

Next, the method for manufacturing a light-emitting device is described.

### (Step of preparing supporting substrate provided with first electrodes and partitions)

First, the supporting substrate 11 is prepared. As the supporting substrate 11 for an active matrix driving-type display device, a substrate in which a drive circuit for individually driving a plurality of organic EL elements is formed beforehand, can be used as the supporting substrate 11. For example, a substrate on which a thin film transistor (TFT) is formed beforehand can be used as the supporting substrate.

Next, on the prepared supporting substrate 11, a plurality of first electrodes 12 are formed in a matrix pattern. The first electrodes 12 are formed, for example, by a method comprising: forming a conductive thin film all over on the supporting substrate 11; and patterning the conductive thin film in a matrix pattern by a photolithography method (in the description below, the "photolithography method" comprises a patterning step such as an etching step performed following a mask pattern forming step). The first electrodes 12 may be patterned, for example, by a method comprising the steps of: arranging a mask in which an opening is formed in a certain portion on the supporting substrate 11; and selectively depositing a conductive material in a prescribed portion on the supporting substrate 11 through the mask. The material for the first electrodes 12 is described below. In the present step, a supporting substrate in which the first electrodes 12 are formed beforehand may be prepared as the supporting substrate 11.

Next, the partitions 17 are formed in a stripe pattern on the supporting substrate 11. The partitions 17 are constituted by an organic substance or an inorganic substance. Examples of the organic substance constituting the partitions 17 include resins such as an acrylic resin, a phenolic resin, and a polyimide resin. Examples of the inorganic substance constituting the partitions 17 include SiOₓ and SiNₓ.

When the partitions 17 comprising an organic substance are formed, first, for example, a positive or negative photosensitive resin is applied all over to the substrate and a prescribed portion is exposed and developed. Furthermore, by curing the resultant coating, the partitions 17 are formed in a stripe pattern. As the photosensitive resin, a photoresist can be used. When the partitions 17 comprising an inorganic substance are formed, a thin film comprising an inorganic substance is formed all over the substrate by a plasma CVD method, a sputtering method, or the like, and next, by removing the prescribed portion of the thin film, the partitions 17 are formed in a stripe pattern. The prescribed portion is removed, for example, by a photolithography method.

To manufacture a light-emitting device 21 having the insulation film 15 in a lattice pattern, the insulation film 15 is formed before the step of forming the partitions 17. The insulation film 15 can be formed in a lattice pattern using, for example, a material exemplified as the materials for the partitions 17 in the same manner as that for forming the partitions 17.

The shape and the arrangement of the partitions 17 are set as appropriate according to the specifications of the display device such as the number of pixels and the resolution and the easiness of manufacturing. For example, the width L1 of each of the partitions 17 in the column direction Y is around 5 µm to 50 µm. The height L2 of the partition 17 is around 0.5 µm to 5 µm. The interval L3 between the partitions 17 adjacent to each other in the column direction Y, that is, the width L3 of the concave portion 18 in the column direction Y is around 10 µm to 200 µm. The widths of each of the first electrodes 12 in the line direction X and the column direction Y are individually around 10 µm to 400 µm.

### (Step of forming organic EL layer)

In the present step, for supplying an ink comprising a material to be the organic EL layer (in the present embodiment, a hole injection layer) to the each concave portion along the line direction, the ink is supplied to one concave portion 18 between the partitions 17 a plurality of times by shifting an ink supply position in the column direction and solidifying the ink, thereby forming the organic EL layer.
In the present step, for example, by reciprocating the supply position of the ink comprising a material to be the organic EL layer from one end to the other end of the line direction and from the other end to one end of the line direction in one reciprocation or two or more reciprocations, and by changing an ink supply position during the ink supply from the one end to the other end and an ink supply position during the ink supply from the other end to the one end in the column direction, the ink is supplied to each concave portion 18, and the ink is solidified to form the organic EL layer.

The method for supplying the ink to the concave portion 18 between the partitions 17 may be any method so long as the method is an applying method capable of selectively supplying the ink between the partitions 17. Such a method may be a nozzle printing method or an inkjet method and among them, the nozzle printing method is preferred. By the inkjet method in which the ink is dropped intermittently, the ink is attached to the substrate at an interval. The attached ink wet-spreads on the substrate, so that usually, a continuous coating film can be obtained. However, when the ink does not satisfactorily wet-spread on the substrate, a hole may possibly be formed in the coating film. By contrast, by the nozzle printing method in which the liquid columnar ink is continuously supplied, the ink is continuously applied onto the substrate, it is unlikely that a hole is formed in the coating film and a continuous coating film can be obtained.

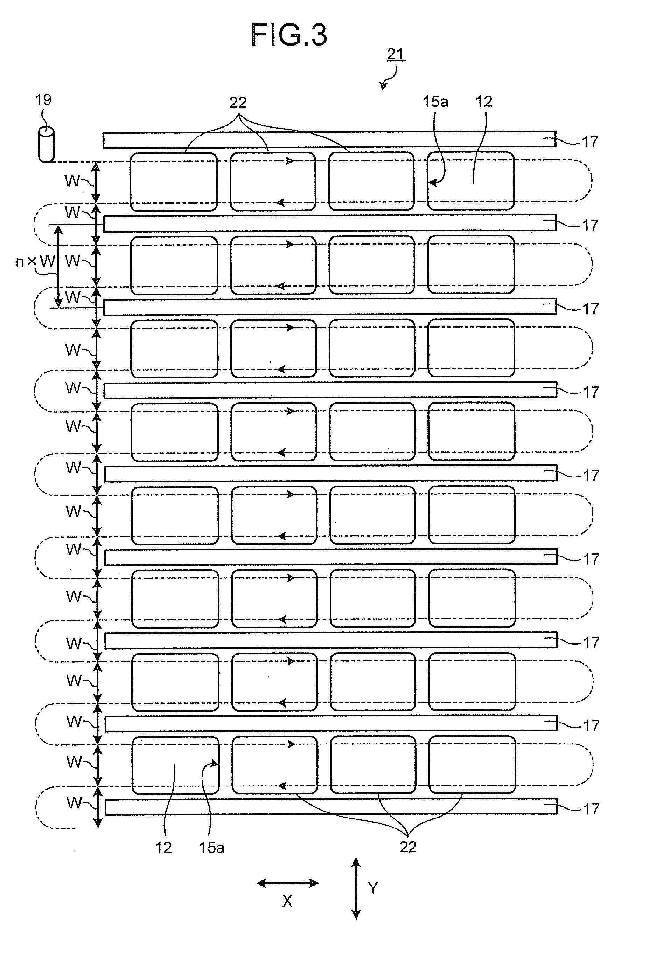

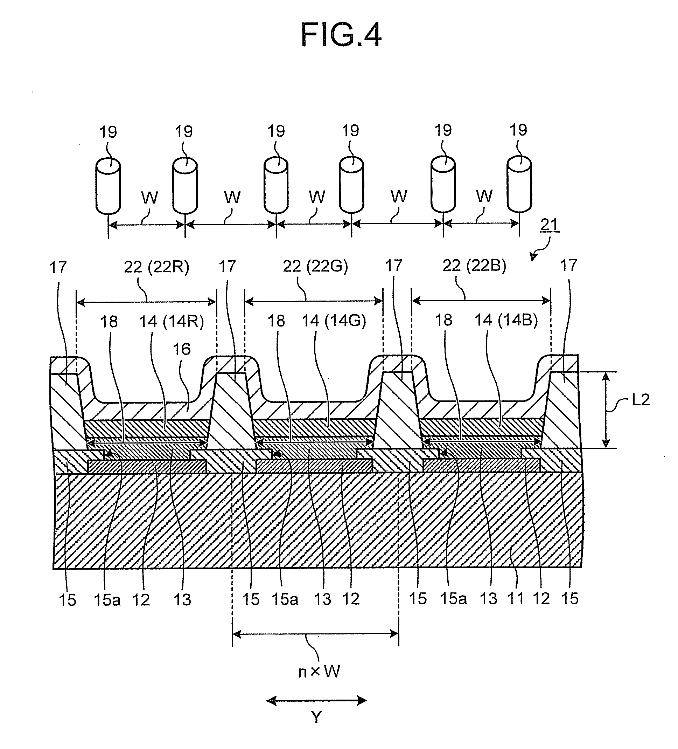

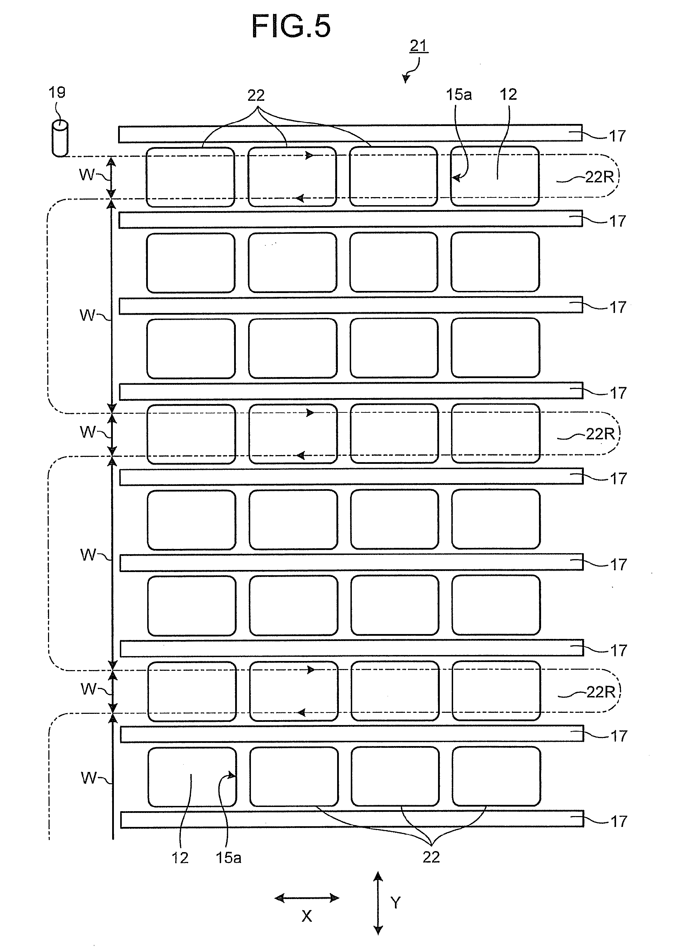

Referring to FIG. 3, FIG. 4, and FIG. 5, the ink supplying step for supplying the ink by the nozzle printing method is described. FIG. 3 is a drawing (1) schematically illustrating ink supply. FIG. 4 is a drawing (2) schematically illustrating ink supply. FIG. 5 is a drawing (3) schematically illustrating ink supply.

In the nozzle printing method, the ink is supplied to each line (concave portion 18) by a one-stroke sketch. That is, while discharging the liquid columnar ink through a nozzle 19 placed over the supporting substrate 11, the nozzle 19 is reciprocated in the line direction X and during the turn of the reciprocation of the nozzle 19, the supporting substrate 11 is moved in the column direction Y by a prescribed distance to supply the ink to each line.

In FIG. 3, the track of the nozzle 19 over the supporting substrate 11 is indicated by a two-dot chain line. In the present embodiment, the ink supplying step in which the ink is supplied from one end to the other end of the concave portion 18 along the line direction X is performed twice with shifting the ink supply position in the column direction for each concave portion 18 between the partitions 17. That is, in this ink supplying step, for each concave portion 18, the ink is supplied to one end to the other end (out-bound), the supply position is turned, and further the ink is supplied to the other end to the one end (in-bound), so that the ink supply position is reciprocated in one reciprocation to supply the ink.

An interval W of the ink supply position in the column direction Y in the ink supplying step does not have to be an equal interval. The interval W is preferably an equal interval. The interval W comprises two types of intervals such as (1) an interval generated when the ink supply position is reciprocated in one concave portion 18 and (2) an interval generated when the ink supply position is reciprocated in another concave portion 18 adjacent to the one concave portion 18.

Thus, by making the interval W of the supply position in the column direction Y equal, the setting of the device for supplying the ink using the nozzle printing method can be facilitated. When the interval W is made equal, the partition is arranged such that the interval between the centers of the partitions in the column direction becomes an integral multiple of two or more times the interval between the supply positions. Specifically, the partitions 17 are arranged such that the interval between the centers of the partitions 17 adjacent to each other in the column direction becomes n x W (the symbol "n" represents a natural number of 2 or more). The symbol n agrees with the number of times of performing the ink supply in which the ink is supplied to one end to the other end or the other end to the one end of the line direction along the line direction X for each concave portion 18. In the present embodiment, the ink supply is performed twice for each concave portion 18, that is, the ink supply is performed in one reciprocation, and n is 2.

As illustrated in FIG. 3, in the present embodiment, by repeating the steps (1) to (4) below in this order while discharging the liquid columnar ink through the nozzle 19, the ink is supplied to each concave portion 18:
(1) moving the nozzle 19 from one end to the other end of the line direction X (out-bound);
(2) moving the supporting substrate 11 in one direction of the column direction Y by the interval W;
(3) moving the nozzle 19 from the other end to the one end of the line direction X (in-bound); and
(4) moving the supporting substrate in the one direction of the column direction Y by the interval W.

Thus, by supplying the ink to each concave portion 18 in a plurality of times, the ink can be supplied so as to reliably cover the space between the partitions 17 while preventing the occurrence of an uncoated portion.
In one ink supplying step (out-bound or in-bound), it is preferred to supply the ink a plurality of times such that the each amount of the ink supplied to one concave portion 18 in a plurality of times is less than the amount of the ink wet-spreading in all the regions between the partitions 17.
Specifically, for example, it is preferred that in each of the out-bound in which the ink is supplied to the one end to the other end and the in-bound in which the ink is supplied to the other end to the one end, the ink in an amount less than the amount required for supplying the ink to all the regions of the concave portion 18 be supplied and the ink is supplied a plurality of times such that ink supplied to the concave portion 18 is joined to each other and spread to all the regions of the concave portion 18.
When the ink is supplied to the concave portion 18 a plurality of times, it is satisfactory that the ink supplied a plurality of times is joined to each other and as a result thereof, the ink spreads to all the regions between the partitions 17, so that by each supplying the ink in an amount less than the amount of the ink spreading to all the regions between the partitions 17 in one ink supplying step, the suppression of the used amount of the ink becomes possible.

The hole injection layer 13 corresponding to the organic EL layer is formed by solidifying the ink supplied between the partitions 17. The solidification of the ink can be performed, for example, by removing the solvent. The removal of the solvent can be performed by natural drying, heating drying, vacuum drying, or the like.

When the ink used comprising a material to be polymerized by applying energy such as light and heat is used, the hole injection layer 13 can be formed by solidifying the ink by applying energy such as light and heat after the ink is supplied in the concave portion 18.

### (Step of forming light-emitting layer)

Next, the light-emitting layer 14 is formed. As described above, when a color display device is manufactured, for forming three types of organic EL elements 22, the material for the light-emitting layer 14 is necessary to be painted in different colors for each line. For example, when three types of light-emitting layers 14 individually are formed for each line, it is necessary to apply red ink comprising a material emitting red light, green ink comprising a material emitting green light, and blue ink comprising a material emitting blue light to each line individually with an interval of two lines in the column direction Y. Then, by applying red ink, green ink, and blue ink sequentially to a prescribed line respectively, each of the three types of light-emitting layers 14 can be coated to form a film. The method for applying red ink, green ink, and blue ink sequentially to a prescribed line may be prescribed applying methods such as a printing method, an inkjet method, or a nozzle printing method. For example, by the nozzle printing method, in the same manner as the above-described method for forming the hole injection layer, the ink can be applied.

As illustrated in FIG. 5, when red ink, green ink, and blue ink are applied individually with an interval of two lines in the column direction Y, the interval W of the supply position in the column direction cannot be made equal. For example, at the step of supplying red ink, for each space between the partitions 17 to which the red ink should be supplied, the ink supply may be performed a plurality of times. Thus, by performing the ink supply in a plurality of times for each space between the partitions 17, while preventing the occurrence of an uncoated portion, red ink can be supplied so as to reliably cover the space between the partitions 17. Green ink and blue ink can also be supplied to a prescribed space between the partitions 17 in the same manner as the red ink. In the case of a device in which one type of light-emitting layer 14 is provided such as a display device achieving a color display using a color filter and a monochrome display device, it is not necessary to supply different types of the ink comprising a material to be the light-emitting layer 14 for each line, so that the ink comprising a material to be the light-emitting layer 14 can be supplied to each space between the partitions 17 by the same method as the method above-described as the method for supplying the ink comprising a material to be the hole injection layer 13.

The light-emitting layer 14 is formed by solidifying the ink supplied to a space between the partitions 17. The solidification of the ink can be performed, for example, by removing the solvent. The removal of the solvent can be performed by natural drying, heat drying, vacuum drying, or the like. When the used ink comprises a material polymerized by applying energy such as light and heat, the light-emitting layer may be solidified by applying energy such as light and heat to the ink after the ink is supplied.

After the light-emitting layer 14 is formed, if necessary, a prescribed organic layer or inorganic layer and the like are formed by a prescribed method. These layers may be formed using a prescribed applying method such as a printing method, an inkjet method, and a nozzle printing method and further, a prescribed dry method.

### (Step of forming second electrode)

Next, the second electrode 16 is formed. As described above, in the present embodiment, the second electrode 16 is formed all over on the supporting substrate 11 (all over the exposed surface). The organic EL elements 22 are formed on the supporting substrate 11 by forming the second electrode 16.

In the above-described the method for manufacturing the light-emitting device, the ink is supplied to each space between the partitions 17 in a plurality of times, so that even when the light-emitting device is a light-emitting device in which the size of each pixel is large and the interval between the partitions 17 is large, the light-emitting device can prevent the occurrence of an uncoated portion and the formation of a hole in the organic EL layer. The occurrence of an element failure can be thus prevented and the yield can be enhanced.
In the above descriptions, although a method for supplying the ink using one nozzle 19 is described, the nozzle 19 may be used in a plurality. By using a plurality of nozzles 19 discharging the ink and by discharging the ink simultaneously through the nozzles 19, several ink supplying steps can be performed at once. The time required for the ink supplying steps can be thus shortened. The nozzles 19 are not necessary to be placed in a row in the column direction Y, but may be placed with an interval in the column direction Y, that is, an interval corresponding to the interval W of the supply position in the column direction, and may be placed with a prescribed interval in the line direction X according to the necessity of an installing space.

### <Composition of organic EL element>

As described above, although the organic EL element 22 can take various layer compositions, hereinafter, the layer structure of the organic EL element 22, the composition of each layer, and the forming method of each layer are described more in detail.

As described above, the organic EL element 22 comprises a pair of electrodes (the first electrode 12 and the second electrode 16) and one or a plurality of organic EL layers provided between the electrodes and has at least one light-emitting layer 14 as one or a plurality of organic layers. The organic EL element 22 may comprise a layer comprising an inorganic substance and an organic substance, an inorganic layer, and the like. The organic substance comprised in the organic layer may be a low molecular compound, a macromolecular compound, or a mixture of a low molecular compound and a macromolecular compound. The organic layer comprises preferably a macromolecular compound and includes preferably a macromolecular compound having a number average molecular weight in terms of polystyrene of 10³ to 10⁸.

Examples of the organic EL layer provided between the cathode and the light-emitting layer include an electron injection layer, an electron transport layer, and a hole block layer. When, between the cathode and the light-emitting layer, both of the electron injection layer and the electron transport layer are provided, a layer nearer to the cathode is called an electron injection layer and a layer nearer to the light-emitting layer is called an electron transport layer. The organic EL layers provided between the anode and the light-emitting layer may be a hole injection layer, a hole transport layer, or an electron block layer. When both of the hole injection layer and the hole transport layer are provided, a layer nearer to the anode is called a hole injection layer and a layer nearer to the light-emitting layer is called a hole transport layer.

Examples of the composition of the organic EL element in the present embodiment are illustrated as follows:
a) anode / light-emitting layer / cathode;
b) anode / hole injection layer / light-emitting layer /cathode;
c) anode / hole injection layer / light-emitting layer /electron injection layer / cathode;
d) anode / hole injection layer / light-emitting layer /electron transport layer / cathode;
e) anode / hole injection layer / light-emitting layer /electron transport layer / electron injection layer /cathode;
f) anode / hole transport layer / light-emitting layer /cathode;
g) anode / hole transport layer / light-emitting layer /electron injection layer / cathode;
h) anode / hole transport layer / light-emitting layer /electron transport layer / cathode;
i) anode / hole transport layer / light-emitting layer /electron transport layer / electron injection layer /cathode;
j) anode / hole injection layer / hole transport layer /light-emitting layer / cathode;
k) anode / hole injection layer / hole transport layer /light-emitting layer / electron injection layer / cathode;
l) anode / hole injection layer / hole transport layer /light-emitting layer / electron transport layer / cathode;
m) anode / hole injection layer / hole transport layer /light-emitting layer / electron transport layer / electron injection layer / cathode;
n) anode / light-emitting layer / electron injection layer / cathode;
o) anode / light-emitting layer / electron transport layer / cathode; and
p) anode / light-emitting layer / electron transport layer / electron injection layer / cathode.
Here, the symbol "/" indicates that the layers interposing the symbol "/" are layered adjacently. The same applies to the description below.

The organic EL element 22 of the present embodiment may have two or more light-emitting layers. When, in any one of the above layer compositions a) to p), a layered body sandwiched between the anode and the cathode is assumed to be "structural unit A", as the composition of the organic EL element 22 having two light-emitting layers, there can be mentioned a layers composition described in q) below. Two layer compositions (structural unit A) may be the same as or different from each other.
q) anode / (structural unit A) / charge generating layer /(structural unit A) / cathode
When "(structural unit A)/charge generating layer" is assumed to be "structural unit B", as the composition of an organic EL element having three or more light-emitting layers, there can be mentioned a layer composition described in r) below.
r) anode / (structural unit B)x / (structural unit A) /cathode
The symbol "x" represents an integer of two or more and "(structural unit B)x" represents a layered body formed by layering x layers of (structural unit B). The layer compositions of a plurality of (structural unit B) may be the same as or different from each other.

Here, the charge generating layer is a layer generating a hole and an electron by applying an electric field to the layer. Examples of the charge generating layer include a thin film composed of vanadium oxide, indium tin oxide (ITO), molybdenum oxide, and the like.

In the organic EL element 22, the anode among the pair of electrodes comprising the anode and the cathode may be provided on the supporting substrate 11 nearer to the supporting substrate 11 than the cathode, or the cathode may be provided on the supporting substrate nearer to the supporting substrate 11 than the anode. For example, the organic EL element may be an organic EL element having a layered structure on the supporting substrate with layers in a layer order from the right end in the above layer compositions a) to r), or an organic EL element having a layered structure on the supporting substrate with layers in a layer order from the left end in the above layer compositions a) to r).

The order of stacking layers, the number of layers, and the thickness of each layer can be set as appropriate, taking into consideration light-emitting efficiency and element life.

Next, the material and the method for forming each layer constituting the organic EL element 22 are more specifically described.

### <Anode>

In the case of an organic EL element 22 having a composition in which light emitted from the light-emitting layer 14 is emitted out of the element through the anode 12, an electrode exhibiting optical transparency is used for the anode 12. As the electrode exhibiting optical transparency, a thin film of a metal oxide, a metal sulfide, or a metal can be used and a material having high electric conductivity and high light transmittance is preferably used. Specifically, as the electrode exhibiting optical transparency, there is used a thin film composed of indium oxide, zinc oxide, tin oxide, ITO, indium zinc oxide (IZO), gold, platinum, silver, copper, or the like and among them, a thin film composed of ITO, IZO, or tin oxide is preferably used.

Examples of the forming method of the anode include a vacuum evaporation method, a sputtering method, an ion plating method, and a plating method. An organic transparent conductive film of a polyamine or derivatives thereof, a polythiophene or derivatives thereof, or the like may be used as the anode.

The film thickness of the anode is set as appropriate, taking into consideration required characteristics and easiness of film forming. The film thickness of the anode is, for example 10 nm to 10 µm, preferably 20 nm to 1 µm, and further preferably 50 nm to 500 nm.

### <Hole injection layer>

Examples of the hole injection material constituting the hole injection layer 13 include: an oxide such as a vanadium oxide, a molybdenum oxide, a ruthenium oxide, and an aluminum oxide; phenylamine compound; a star burst-type amine compound; phthalocyanine compound; amorphous carbon; polyaniline; and polythiophene derivative.

The film-forming method of the hole injection layer 13 may be film forming from a solution comprising a hole injection material. For example, the hole injection layer 13 can be formed by forming a film by a prescribed coating method with a solution comprising a hole injection material and by solidifying the film.

The solvent of the solution comprising hole injection material is not particularly limited so long as the solvent is a solvent capable of dissolving the hole injection material and examples thereof include: a chlorinated solvent such as chloroform, methylene chloride, and dichloroethane; an ether solvent such as tetrahydrofuran; an aromatic hydrocarbon solvent such as toluene and xylene; a ketone solvent such as acetone and methyl ethyl ketone; an ester solvent such as ethyl acetate, butyl acetate, and ethylcellosolve acetate; and water.

Examples of the coating method include a spin coating method, a casting method, a micro gravure coating method, a gravure coating method, a bar coating method, a roll coating method, a wire bar coating method, a dip coating method, a spray coating method, a screen printing method, a flexo printing method, an off-set printing method, and an inkjet printing method. As the coating method, the nozzle printing method described in the embodiment of the present invention is preferable.

The film thickness of the hole injection layer 13 is set as appropriate, taking into consideration required characteristics and easiness of film forming. The film thickness of the hole injection layer 13 is, for example 1 nm to 1 µm, preferably 2 nm to 500 nm, and further preferably 5 nm to 200 nm.

### <Hole transport layer>

Examples of the hole transport material constituting the hole transport layer include polyvinyl carbazole or a derivative thereof, polysilane or a derivative thereof, a polysiloxane derivative having an aromatic amine in side chains or a main chain, a pyrazoline derivative, an arylamine derivative, a stilbene derivative, a triphenyldiamine derivative, polyaniline or a derivative thereof, polythiophene or a derivative thereof, polyarylamine or a derivative thereof, polypyrrole or a derivative thereof, poly(p-phenylenevinylene) or a derivative thereof, and poly(2,5-thienylenevinylene) or a derivative thereof.

Among these hole transport materials, preferred are macromolecular hole transport materials such as polyvinyl carbazole or a derivative thereof, polysilane or a derivative thereof, a polysiloxane derivative having an aromatic amine compound group in side chains or a main chain, polyaniline or a derivative thereof, polythiophene or a derivative thereof, polyarylamine or a derivative thereof, poly(p-phenylenevinylene) or a derivative thereof, and poly(2,5-thienylenevinylene) or a derivative thereof, and further preferred are polyvinyl carbazole or a derivative thereof, polysilane or a derivative thereof, and a polysiloxane derivative having aromatic amine in side chains or a main chain. A low molecular hole transport material is preferably used by being dispersed in a macromolecular binder.

The film-forming method of the hole transport layer is not particularly limited. The film-forming method using a low molecular hole transport material may be film forming from a mixture comprising a macromolecular binder and a hole transport material. The film-forming method using a macromolecular hole transport material comprise film forming from a solution comprising a hole transport material.

The solvent used for film forming from the solution is not particularly limited so long as the solvent can dissolve the hole transport material. Examples of the solvent include a chlorinated solvent such as chloroform, methylene chloride, and dichloroethane; a ether solvent such as tetrahydrofuran; a aromatic hydrocarbon solvent such as toluene and xylene; a ketone solvent such as a acetone and methyl ethyl ketone; and a ester solvent such as ethyl acetate, butyl acetate, and ethylcellosolve acetate.

The film-forming method from the solution may be the same applying methods as the above-described film-forming method of the hole injection layer.

As the macromolecular binder to be mixed, a binder that does not extremely inhibit the electric charge transport is preferred and a binder that weakly absorbs visible light is preferably used. Examples of such a macromolecular binder include polycarbonate, polyacrylate, polymethyl acrylate, polymethyl methacrylate, polystyrene, polyvinyl chloride, and polysiloxane.

The film thickness of the hole transport layer is set as appropriate, taking into consideration required characteristics and easiness of film forming. The film thickness of the hole transport layer is, for example, 1 nm to 1 µm, preferably 2 nm to 500 nm, and further preferably 5 nm to 200 nm.

### <Light-emitting layer>

The light-emitting layer 14 is usually formed mainly from an organic substance emitting fluorescence and/or phosphorescence, or this organic substance and a dopant assisting the organic substance. The dopant is blended, for example, for enhancing light-emitting efficiency or changing the light-emitting wavelength. The organic substance constituting the light-emitting layer 14 may be a low molecular compound or a macromolecular compound and when the light-emitting layer 14 is formed by a coating method, the light-emitting layer 14 comprises preferably a macromolecular compound. The number average molecular in terms of polystyrene of the macromolecular compound constituting the light-emitting layer 14 is for example about 10³ to 10⁸. Examples of the light-emitting material constituting the light-emitting layer 14 include a dye material, a metal complex material, a macromolecular material, and a dopant material below.

### (Dye materials)

Examples of the dye materials include a cyclopentamine derivative, a tetraphenylbutadiene derivative, a triphenylamine derivative, an oxadiazole derivative, a pyrazoloquinoline derivative, a distyrylbenzene derivative, a distyrylarylene derivative, a pyrrole derivative, a thiophene ring compound, a pyridine ring compound, a perinone derivative, a perylene derivative, an oligothiophene derivative, an oxadiazole dimer, a pyrazoline dimer, a quinacridone derivative, and a coumarin derivative.

### (Metal complex materials)

Examples of the metal complex materials include metal complexes having as a central metal, a rare metal such as Tb, Eu, and Dy, or Al, Zn, Be, Ir, or Pt and having as a ligand, an oxadiazole, thiadiazole, phenylpyridine, phenylbenzimidazole, or quinoline structure. Examples of the metal complexes include metal complexes having light-emitting from a triplet excited state such as iridium complexes and platinum complexes, aluminum-quinolinole complexes, benzoquinolinol-beryllium complexes, benzoxazolyl-zinc complexes, benzothiazole-zinc complexes, azomethyl-zinc complexes, porphyrin-zinc complexes, and phenanthroline-europium complexes.

### (Macromolecular materials)

Examples of the macromolecular materials include a poly-p-phenylenevinylene derivative, a polythiophene derivative, a poly-p-phenylene derivative, a polysilane derivative, a polyacetylene derivative, a polyfluorene derivative, a polyvinylcarbazole derivative, and the materials prepared by polymerizing the above dye materials or metal complex materials.

Among the above light-emitting materials, examples of the materials emitting blue light include a distyrylarylene derivative, an oxadiazole derivative, polymers of these derivatives, a polyvinylcarbazole derivative, a poly-p-phenylene derivative, and a polyfluorene derivative. Among them, preferred are macromolecular materials such as a polyvinylcarbazole derivative, a poly-p-phenylene derivative, and a polyfluorene derivative.

The materials emitting green light may be a quinacridone derivative, a coumarin derivative, polymers of these derivatives, a poly-p-phenylenevinylene derivative, and a polyfluorene derivative. Among them, preferred are macromolecular materials such as a poly-p-phenylenevinylene derivative and a polyfluorene derivative.

Examples of the materials emitting red light include a coumarin derivative, a thiophene ring compound, polymers of these compounds, a poly-p-phenylenevinylene derivative, a polythiophene derivative, and a polyfluorene derivative. Among them, preferred are macromolecular materials such as a poly-p-phenylenevinylene derivative, a polythiophene derivative, and a polyfluorene derivative.

### (Dopant materials)

Examples of the dopant materials include a perylene derivative, a coumarin derivative, a rubrene derivative, a quinacridone derivative, a squarylium derivative, a porphyrin derivative, a styryl dye, a tetracene derivative, a pyrazolone derivative, decacyclene, and phenoxazone. The thickness of such a light-emitting layer 14 is usually 2 nm to 200 nm.

Examples of the film-forming method of the light-emitting layer 14 include a method for film forming from the solution, a vacuum evaporation method, and a transfer method. The solvent used for film forming from the solution may be the same solvent as the solvent used for the above-described film forming of the hole injection layer 13 from the solution.

Examples of the method for applying the solution in film forming from the solution include a coating method such as a spin coating method, a casting method, a micro gravure coating method, a gravure coating method, a bar coating method, a roll coating method, a wire bar coating method, a dip coating method, a slit coating method, a capillary coating method, a spray coating method, and a nozzle printing method; and applying methods such as a gravure printing method, a screen printing method, a flexo printing method, an off-set printing method, a reverse printing method, and an inkjet printing method. As the applying method, the nozzle printing method of the present invention described above as one embodiment is preferred.

### <Electron transport layer>

As the electron transport material constituting the electron transport layer, a publicly-known electron transport material can be used. Examples of the electron transport material include an oxadiazole derivative, anthraquinodimethane or a derivative thereof, benzoquinone or a derivative thereof, naphthoquinone or a derivative thereof, anthraquinone or a derivative thereof, tetracyanoanthraquinodimethane or a derivative thereof, a fluorenone derivative, diphenyldicyanoethylene or a derivative thereof, a diphenoquinone derivative, a metal complex of 8-hydroxyquinoline or a derivative thereof, polyquinoline or a derivative thereof, polyquinoxaline or a derivative thereof, and polyfluorene or a derivative thereof.

Among them, as the electron transport material, preferred are an oxadiazole derivative, benzoquinone or a derivative thereof, anthraquinone or a derivative thereof, a metal complex of 8-hydroxyquinoline or a derivative thereof, polyquinoline or a derivative thereof, polyquinoxaline or a derivative thereof, and polyfluorene or a derivative thereof, and further preferred are 2-(4-biphenylyl)-5-(4-tert-butylphenyl)-1,3,4-oxadiazole, benzoquinone, anthraquinone, tris(8-quinolinol) aluminum, and polyquinoline.

The film-forming method of the electron transport layer is not particularly limited. The film-forming method using a low molecular electron transport material may be a vacuum evaporation method from powder and film forming from a solution or a molten state. The film-forming method using a macromolecular electron transport material may be film forming from a solution or a molten state. In the case of film forming from a solution or a molten state, a macromolecular binder may be used in combination. The film-forming method of an electron transport layer from a solution may be the same film-forming method as the above-described film-forming method of the hole injection layer from the solution.

The film thickness of the electron transport layer is set as appropriate, taking into consideration required characteristics and easiness of film forming. The film thickness of the electron transport layer is, for example 1 nm to 1 µm, preferably 2 nm to 500 nm, and further preferably 5 nm to 200 nm.

### <Electron injection layer>

As the material constituting the electron injection layer, an optimal material is selected as appropriate according to the type of the light-emitting layer 14. Examples of the material constituting the electron injection layer include an alkali metal, an alkaline earth metal, an alloy comprising one or more types of an alkali metal and an alkaline earth metal, an oxide of an alkali metal or an alkaline earth metal, a halide of an alkali metal or an alkaline earth metal, or a carbonate of an alkali metal or an alkaline earth metal, and mixtures of these substances. Examples of the alkali metal and the oxide of the alkali metal, the halide of the alkali metal, and the carbonate of the alkali metal include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkaline earth metal and the oxide, the halide, and the carbonate of the alkaline earth metal include magnesium, calcium, barium, strontium, magnesium oxide, magnesium fluoride, calcium oxide, calcium fluoride, barium oxide, barium fluoride, strontium oxide, strontium fluoride, and magnesium carbonate.

The electron injection layer may be constituted with a layered body prepared by stacking two or more layers. Examples of the layered body include a layered body of a LiF layer and a Ca layer. The electron injection layer is formed by an evaporation method, a sputtering method, a printing method, or the like. The film thickness of the electron injection layer is preferably around 1 nm to 1 µm.

### <Cathode>

The material for the cathode 16 is preferably a material having a small work function and a high electric conductivity and capable of easily injecting electrons into the light-emitting layer 14. An organic EL element 22 retrieving light from the side of the anode 12 reflects light emitted from the light-emitting layer 14 on the cathode 16 to the anode 12 side, so that the material for the cathode 16 is preferably a material having a high visible light reflectivity. The materials for the cathode 16 may be, for example, a alkali metal, an alkaline earth metal, a transition metal, and a metal of Group 13 in the Periodic Table.

Examples of the materials for the cathode 16 include: a metal such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium; an alloy of two or more types of these metals; an alloy of one or more types of these metals with one or more types of gold, silver, platinum, copper, manganese, titanium, cobalt, nickel, tungsten, and tin; and a graphite or a graphite intercalation compound. Examples of the alloys include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy. As the cathode, a transparent conductive electrode comprising a conductive metal oxide and a conductive organic substance can be used. Specific examples of the conductive metal oxides include indium oxide, zinc oxide, tin oxide, ITO, and IZO. Examples of the conductive organic substances include a polyaniline or a derivative thereof and a polythiophene or a derivative thereof. The cathode may be constituted by a layered body prepared by stacking two or more layers. The electron injection layer may be used as the cathode.

The film thickness of the cathode 16 is set as appropriate, taking into consideration required conductivity and easiness of film forming. The film thickness of the cathode 16 is, for example 10 nm to 10 µm, preferably 20 nm to 1 µm, further preferably 50 nm to 500 nm.

Examples of the method for forming the cathode 16 include a vacuum evaporation method, a sputtering method, and a laminate method for thermocompression-bonding a metal thin film.

### EXPLANATIONS OF LETTERS OR NUMERALS

- 11: Supporting substrate
- 12: First electrode (anode)
- 13: Hole injection layer
- 14: Light-emitting layer
- 15: Insulation film
- 15a: Opening
- 16: Second electrode (cathode)
- 17: Partition
- 18: Concave portion
- 19: Nozzle
- 21: Light-emitting device
- 22: Organic EL element

## Claims

1. A method for manufacturing a light-emitting device that comprises a supporting substrate, a plurality of partitions extending in a prescribed line direction on the supporting substrate and provided at a prescribed interval in a column direction that is a different direction from the line direction, and a plurality of organic electroluminescent elements provided in a concave portion that is between the partitions, each element comprising a first electrode, a second electrode, an organic electroluminescent layer sandwiched between the first electrode and the second electrode, the method comprising the steps of:
preparing the supporting substrate provided with the first electrode of each organic electroluminescent element and the partitions;
supplying an ink comprising a material to be the organic electroluminescent layer to one concave portion a plurality of times by shifting an ink supply position in the column direction to supply the ink to each concave portion along the line direction and solidifying the ink, thereby forming the organic electroluminescent layer; and
forming the second electrode.

2. The method for manufacturing the light-emitting device according to claim 1, wherein the step of forming the organic electroluminescent layer comprises: supplying the ink comprising a material to be the organic electroluminescent layer to the each concave portion by reciprocating the supply position of the ink from one end to the other end of the line direction and from the other end to the one end of the line direction, in one or two or more times, with shifting the ink supply position when supplying the ink from the one end to the other end and the ink supply position when supplying the ink from the other end to the one end, in the column direction; and solidifying the ink, thereby forming the organic electroluminescent layer.

3. The method for manufacturing the light-emitting device according to claim 1, wherein at the step of forming the organic electroluminescent layer, an interval between the supply positions in the each concave portion that are different from each other in the column direction is made equal, and
the partitions are provided such that the interval between centers of the partitions in the column direction becomes an integral multiple of two or more times the interval between the supply positions.

4. The method for manufacturing the light-emitting device according to claim 1, wherein at the step of forming the organic electroluminescent layer, the ink is supplied such that each amount of the ink supplied to one concave portion a plurality of times is less than an amount of the ink required for supplying the ink to all the regions of the concave portion and the ink supplied a plurality of times to the concave portion is joined to each other and spread to all the regions of the concave portion.

5. The method for manufacturing the light-emitting device according to claim 1, wherein at the step of forming the organic electroluminescent layer, the ink is discharged simultaneously through a plurality of nozzles using a plurality of nozzles discharging the ink.
